# EUROPÄISCHE PATENTSCHRIFT

(11) **EP 0 277 693 B1**
(45) Veröffentlichungstag und Bekanntmachung des Hinweises auf die Patenterteilung: **25.08.1993**
(21) Anmeldenummer: 88200154.8
(22) Anmeldetag: 29.01.1988
(51) Int. Cl.: H03D 7/12

(54) **Schaltungsanordnung eines Mischers in einem HF-Tuner**
Circuit arrangement for a mixer in a HF tuner
Montage d'un mélangeur dans un circuit d'accord HF

(30) Priorität: 05.02.1987 DE 3703408
(43) Veröffentlichungstag der Anmeldung: 10.08.1988
(73) Patentinhaber: Philips Patentverwaltung GmbH, 22335 Hamburg (DE); Philips Electronics N.V., 5621 BA Eindhoven (NL)
(72) Erfinder: Kupfer, Karl-Heinz, D-4150 Krefeld 29 (DE)
(74) Vertreter: Kupfermann, Fritz-Joachim, Dipl.-Ing.

(56) Entgegenhaltungen:
- DE-A- 1 924 680
- GB-A- 1 114 204

## Beschreibung

Die Erfindung bezieht sich auf eine Schaltungsanordnung für einen HF-Tuner, vorzugsweise einen Fernseh-Tuner, zur Ankopplung eines ZF-Kreises an den Ausgang eines Mischers, der einen in Basis-Schaltung arbeitenden Transistor aufweist, wobei zwischen dessen Kollektor und den ZF-Kreis eine Verstärkerstufe geschaltet ist, die einen in Emitterschaltung arbeitenden Transistor aufweist, dessen Basis gleichstrommäßig mit dem Kollektor des Mischer-Transistors und dessen Kollektor mit dem ZF-Kreis verbunden ist.

Eine derartige Schaltungsanordnung ist aus der GB-A-1 114 204 bekannt und dient dort vor allem dazu, eine Umschaltung des Tuners zwischen verschiedenen Empfangs-Bereichen zu gestatten und für diese Bereiche jeweils eine geeignete Verstärkung zu gewährleisten. Die durch diese bekannte Schaltungsanordnung gelöste Problemstellung besteht also darin, durch geeignete Bandumschaltung einen gleichmäßigen Verstärkungsgang zu erreichen.

Eine Mischstufe mit einem Transistor in Basisschaltung ist aus der AT-A-329 637 (DE-A-19 24 680) bekannt.

Es ist Aufgabe der Erfindung, die eingangs genannte Schaltungsanordnung dahingehend weiterzuentwicklen, daß ein möglichst linearer Mischprozeß und eine hohe lineare Verstärkung erzielt werden.

Diese Aufgabe ist erfindungsgemäß dadurch gelöst, daß die Basis des Verstärker-Transistors über einen Widerstand mit Masse verbunden ist und daß zur Gleichstrom-Gegenkopplung der Emitter des Verstärker-Transistors und die Basis des Misch-Transistors über einen Widerstand miteinander verbunden sind.

Es ist zwischen den Transistor im Mischer und den ZF-Kreis ein Verstärker geschaltet, wobei der Transistor des Mischers in Basisschaltung arbeitet. Die Kollektor-Gleichströme der beiden Transistoren sind getrennt wählbar. Dies gestattet es, den Kollektorstrom des Mischer-Transistors so zu wählen, daß dieser noch möglichst kreuzmodulationsarm arbeitet. Der Strom für den in dem Verstärker arbeitenden Transistor ist unabhängig einstellbar, so daß auch diese Stufe kreuzmodulationsarm arbeitet.

Die Kopplung der Basis des Verstärker-Transistors über einen Widerstand mit. Masse gestattet es, den Kollektorstrom des Mischer-Transistors auf einen gewünschten Wert einzustellen. Der Wert des Widerstandes kann so gewählt werden, daß die Außenimpedanz, auf die der Mischtransistor arbeitet, die sich aus dem Widerstandswert und der Eingangsimpedanz des Verstärkers ergibt, klein gehalten wird, so daß am Kollektor des Mischer-Transistors keine hohen Amplituden entstehen und dieser kreuzmodulationsarm arbeitet.

Es ist bekannt, eine Gleichstrom-Gegenkopplung im Mischer in der Weise vorzusehen, daß Kollektor und Basis des Mischer-Transistors gekoppelt werden. Um die Verstärkerstufen mit in die Gegenkopplung einzubeziehen, ist es vorteilhaft, den Emitter des Verstärker-Transistors und die Basis des Mischer-Transistors einen Widerstand miteinander zu verbinden.

Ein Ausführungsbeispiel der Erfindung wird anhand der Figuren näher erläutert. Es zeigen:
Fig. 1 eine Schaltungsanordnung für einen HF-Tuner mit einem Mischer und einem nachgeschalteten Verstärker im wesentlichen nach der GB-A-1 114 204 und
Fig. 2 die Schaltungsanordnung nach der Erfindung mit einer ZF-Stufe nach Fig. 1 mit einer Gleichstrom-Gegenkopplung zwischen Verstärker und Mischer.

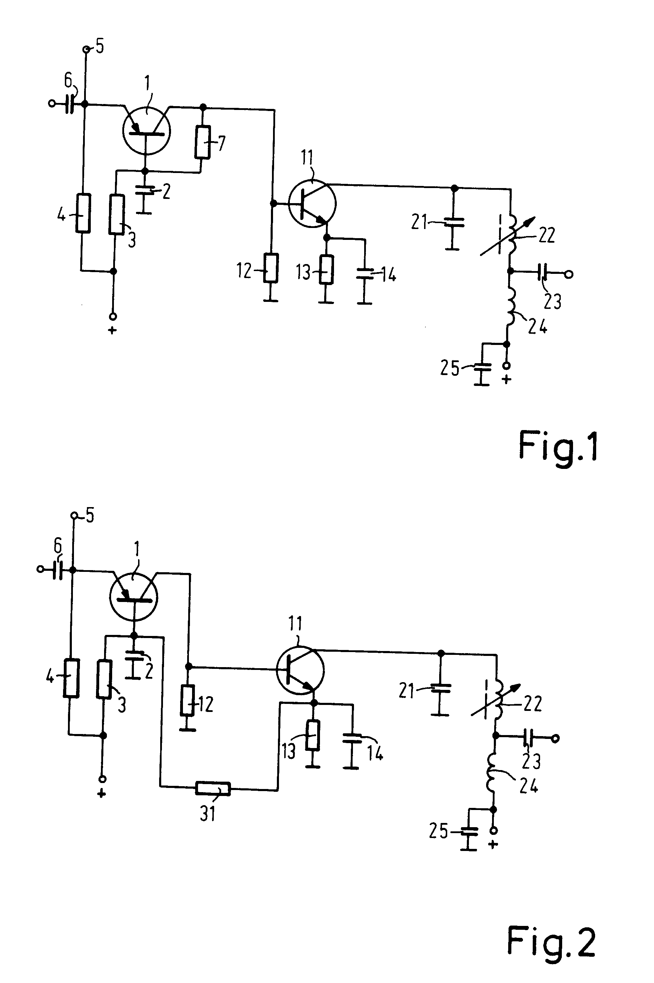

Eine im wesentlichen aus der GB-A-1 114 204 bekannte Schaltungsanordnung für einen Tuner mit einem Mischer, einer Verstärkerstufe und einem ZF-Kreis ist in Fig. 1 dargestellt. In dem Mischer arbeitet ein Transistor 1 in Basisschaltung, dessen Basis über eine Kapazität 2 mit Masse verbunden ist. Ferner sind die Basis des Transistors 1 über einen Widerstand 3 und der Emitter des Transistors 1 über einen Widerstand 4 mit der Spannungsversorgung verbunden. Dem Emitter des Transistors 1 ist über einen Anschluß 5 das Ausgangssignal eines in der Figur nicht dargestellten ZF-Oszillators und über eine Koppelkapazität 6 das HF-Signal zugeführt. Zur Gleichstrom-Gegenkopplung ist zwischen den Kollektor und die Basis des Transistors 1 ein Widerstand 7 geschaltet.

Dem Mischer ist eine Verstärkerstufe nachgeschaltet, in der ein Verstärker-Transistor 11 in Emitterschaltung arbeitet. Der Kollektor des Mischer-Transistors 1 ist dazu gleichstrommäßig mit der Basis des Verstärker-Transistors 11 und über einen Widerstand 12 mit Masse verbunden. Der Emitter des Verstärker-Transistors 11 ist über die Parallelschaltung eines Widerstande 13 und einer Kapazität 14 auf Masse geführt. Dies entspricht der Schaltung nach der GB-A-1 114 204 im UHF/VHF Band III-betrieb.

Der Ausgang dieser Verstärkerstufe, d. h. also der Kollektor des Transistors 11 ist mit dem ZF-Kreis verbunden. Der ZF-Kreis ist aufgebaut aus einer Kapazität 21, die gegen Masse geschaltet ist, und einer veränderbaren Induktivität 22. Hinter der Induktivität 22 wird das ZF-Signal über eine Koppelkapazität 23 ausgekoppelt. Zur Spannungsversorgung des Verstärker-Transistors 11 ist der Verbindungspunkt zwischen der Induktivität 22 und der Kapazität 23 über eine weitere Induktivität 24 mit der Spannungsversorgung verbunden. Eine weitere Kapazität 25 führt von dem Spannungs-Versorgungsanschluß der Induktivität 24 nach Masse, um Signalreste auf Masse abzuführen.

Der Kollektorstrom des in Basisschaltung arbeitenden Mischer-Transistors 1 des Mischers ist in seiner Grundeinstellung durch die Werte der Widerstände 3 und 4 einstellbar. Es gehen jedoch auch die Werte der Widerstände 7 und 12 ein, da der Wert des Widerstandes 12 die Spannung am Ausgang des Mischers beeinfluß. Über den Widerstand 7 findet eine Gegenkopplung statt, deren Wert also von dem Wert des Widerstandes 12 und auch von dem Wert des Gegenkopplungswiderstandes 7 abhängt. Der Arbeitspunkt des Transistors 11 wiederum ist durch geeignete Wahl des Widerstandes 13 einstellbar. Somit können sowohl der Mischtransistor 1, wie auch der Verstärker-Transistor 11 verzerrungsarm arbeiten, wobei gleichwohl eine hohe Verstärkung des Gesamtkonzeptes und somit eine relativ hohe ZF-Signalspannung zu erzielen ist.

Die in Fig. 1 dargestellte Schaltung arbeitet mit einer Gleichstrom-Gegenkopplung lediglich im Mischer. Um die Verstärkerstufe in die Gleichstrom-Gegenkopplung mit einzubeziehen, ist erfindungsgemäß eine Variante der Schaltung entsprechend der in Fig. 2 dargestellten Ausführungsform vorteilhaft. Die in Fig. 2 dargestellte Schaltung unterscheidet sich von der in Fig. 1 dargestellten dadurch, daß die Gleichstrom-Gegenkopplung im Mischer zwischen dem Kollektor und der Basis des Mischer-Transistors 1 weggelassen wurde und ersetzt wurde durch eine Gleichstrom-Gegenkopplung zwischen dem Emitter des Verstärker-Transistors 11 und der Basis des Mischer-Transistors 1, die über einen Widerstand 31 miteinander verbunden sind. Auf diese Weise ist die Verstärkerstufe mit dem Verstärker-Transistor 11 in die Gleichstrom-Gegenkopplung einbezogen.

## Patentansprüche

1. Schaltungsanordnung für einen HF-Tuner, vorzugsweise einen Fernseh-Tuner, zur Ankopplung eines ZF-Kreises an den Ausgang eines Mischers, der einen in Basis-Schaltung arbeitenden Transistor (1) aufweist, wobei zwischen dessen Kollektor und den ZF-Kreis eine Verstärkerstufe (25) geschaltet ist, die einen in Emitterschaltung arbeitenden Transistor (11) aufweist, dessen Basis gleichstrommäßig mit dem Kollektor des Mischer-Transistors (1) und dessen Kollektor mit dem ZF-Kreis (21, 22, 24) verbunden ist,
dadurch gekennzeichnet, daß die Basis des Verstärker-Transistors (11) über einen Widerstand (12) mit Masse verbunden ist und daß zur Gleichstrom-Gegenkopplung der Emitter des Verstärker-Transistors (11) und die Basis des Misch-Transistors über einen Widerstand (31) miteinander verbunden sind.

## Claims

1. A circuit arrangement for an RF-tuner, preferably a television tuner, in which an IF-circuit is coupled to the output of a mixer including a transistor (1) operating in common base configuration, an amplifier stage (25) being arranged between the collector of said mixing transistor and the IF-circuit, which stage includes a transistor (11) operating in common emitter configuration, whose base is DC coupled to the collector of the mixing transistor (1) and whose collector is coupled to the IF-circuit (21, 22, 24), characterized in that the base of the amplifying transistor (11) is coupled to ground *via* a resistor (12) and in that for the purpose of DC negative feedback the emitter of the amplifying transistor (11) is coupled to the base of the mixing transistor *via* a resistor (13).

## Revendications

1. Circuit pour un syntonisateur HF, de préférence un syntonisateur de télévision, pour coupler un circuit FI à la sortie d'un mélangeur présentant un transistor (1) fonctionnant en montage à base commune, circuit dans lequel, entre le collecteur de ce transistor et le circuit FI, est connecté un étage amplificateur (25) présentant un transistor (11) fonctionnant en montage à émetteur commun, transistor dont la base est reliée en courant continu au collecteur du transistor mélangeur (1) et dont le collecteur est relié au circuit FI (21, 22, 24), caractérisé en ce que la base du transistor amplificateur (11) est à la masse à travers une résistance (12) et en ce que, pour la contre-réaction en courant continu, l'émetteur du transistor amplificateur (11) et la base du transistor mélangeur sont reliés entre eux à travers une résistance (31).
